# EUROPÄISCHE PATENTSCHRIFT

(11) **EP 0 895 348 B1**
(45) Veröffentlichungstag und Bekanntmachung des Hinweises auf die Patenterteilung: **02.05.2002**
(21) Anmeldenummer: 98113569.2
(22) Anmeldetag: 20.07.1998
(51) Int. Cl.: H03F 1/30

(54) **Transistor-Verstärkerstufe**
Transistor amplifier stage
Etage amplificateur à transistor

(30) Priorität: 28.07.1997 DE 19732437
(43) Veröffentlichungstag der Anmeldung: 03.02.1999
(73) Patentinhaber: Infineon Technologies AG, 81669 München (DE)
(72) Erfinder: Lohninger, Gerhard, 81549 München (DE)

(56) Entgegenhaltungen:
- FR-A- 2 406 849
- US-A- 3 878 471
- BARANOV A V ET AL: "INVESTIGATION OF THE TEMPERATURE STABILITY OF A BROADBAND MICROWAVEAMPLIFIER-LIMITER*" TELECOMMUNICATIONS AND RADIO ENGINEERING, Bd. 43, Nr. 7, 1. Juli 1988, Seiten 148-150, XP000119010
- PATENT ABSTRACTS OF JAPAN vol. 001, no. 126 (E-056), 20. Oktober 1977 & JP 52 060047 A (NIPPON TELEGR & TELEPH CORP ;OTHERS: 01), 18. Mai 1977
- PATENT ABSTRACTS OF JAPAN vol. 007, no. 218 (E-200), 28. September 1983 & JP 58 108822 A (MATSUSHITA DENKI SANGYO KK), 29. Juni 1983

## Beschreibung

Die Erfindung bezieht sich auf eine Transistor-Verstärkerstufe mit npn-Verstärker-Transistor, der mit seiner Basis an einen Wechselspannungs-Eingangsanschluss, mit seinem Emitter an ein festes Potential und mit seinem Kollektor an einen Wechselspannungs-Ausgangsanschluss gekoppelt ist. Sie bezieht sich insbesondere auf eine Hochfrequenz(HF)-Transistor-Verstärkerstufe.

Es sind verschiedenartige Transistor-Verstärkerstufen bekannt, die jedoch meist den Nachteil haben, dass bei Auslegung auf hohe HF-Verstärkung ihre Gleichstromstabilisierung herabgesetzt ist. Als Beispiel sei hier die Darlington-Stufe genannt, bei der der Emitter eines ersten Transistors mit der Basis eines zweiten Transistors und der Kollektor des zweiten Transistors mit dem Kollektor des ersten Transistors verbunden ist. Weiterhin ist bei dieser bekannten Schaltung die Basis des ersten Transistors über einen ersten elektrischen Widerstand mit dessen Kollektor und über einen zweiten elektrischen Widerstand mit Masse verbunden. Sowohl der Emitter des ersten als auch des zweiten Transistors sind über einen dritten bzw. einen vierten elektrischen Widerstand ebenfalls mit Masse verbunden. Die Basis des ersten Transistors ist an einen Wechselspannungs-Eingangsanschlluß und der Kollektor des zweiten Transistors ist an einen Wechselspannungs-Ausgangsanschluss gekoppelt. Um eine ausreichende Hochfrequenz-Verstärkung des zweiten Transistors zu erzielen, muss der vierte Widerstand mit einem niedrigen Wert ausgelegt sein. Dadurch wird aber die Gleichstrom-Stabilisierung des zweiten Transistors reduziert.

Aus Patent Abstracts of Japan, E-1366 May 18, 1993, Vol. 17/No. 249, (JP-A-4 369 907) ist eine HF-Verstärkerstufe mit Transistoren gemäß Oberbegriff des Patentanspruchs 1 bekannt.

In EP-A-0 544 387 ist ein integrierter Schaltkreis für HF-Verstärkung auf einem MMIC-Chip beschrieben, welcher eine Darlington-Transistorenanordnung aufweist.

Eine Transistor-Verstärkerstufe gemäss dem Oberbegriff des Anspruchs 1 ist aus dem Dokument FR-A-2 406 849 bekannt.

Die Aufgabe der vorliegenden Erfindung besteht darin, eine Transistor-Verstärkerstufe mit einem npn-Verstärker-Transistor zu entwickeln, die eine verbesserte Gleichstrom-Stabilisierung des npn-Verstärker-Transistors gewährleistet.

Diese Aufgabe wird durch eine Verstärkerstufe mit den Merkmalen des Patentanspruches 1 gelöst. Vorteilhafte Weiterbildungen der erfindungsgemäßen Verstärkerstufe sind Gegenstand der Unteransprüche 2 bis 5.

Erfindungsgemäß ist bei der Transistor-Verstärkerstufe der eingangs genannten Art vorgesehen, dass zwischen einem Gleichspannungs-Eingangsanschluss und der Basis des npn-Verstärker-Transistors eine aktive Arbeitspunkt-Stabilisierungseinheit mit einem ersten und einem zweiten pnp-Transistor vorgesehen ist. Der Kollektor des ersten pnp-Transistors ist an die Basis des zweiten pnp-Transistors, die Basis des ersten pnp-Transistors an den Emitter des zweiten pnp-Transistors und der Kollektor des zweiten pnp-Transistors an die Basis des npn-Verstärker-Transistors gekoppelt. Weiterhin ist an den Emitter des zweiten pnp-Transistors ein weiterer Schaltungsanschluss gekoppelt. Die aktive Arbeitspunkt-Stabilisierungseinheit bewirkt eine verbesserte Gleichstromstabilisierung der Transistor-Verstärkersstufe.

Bei einer besonders bevorzugten Weiterbildung der erfindungsgemäßen Transistor-Verstärkerstufe ist ein npn-Vorstufen-Transistors vorgesehen ist, der so an den npn-Verstärker-Tranistor gekoppelt ist, dass er mit diesem zusammen eine Darlington-Verstärkerstufe ausbildet. Von dem npn-Vorstufen-Transistors ist beispielsweise der Emitter an die Basis des npn-Verstärker-Transistors sowie an das feste Potential, der Kollektor an den Kollektor des npn-Verstärker-Transistors und die Basis an den Wechselspannungs-Eingangsanschluß gekoppelt. Zwischen der Basis und dem Kollektor des npn-Vorstufen-Transistors sowie zwischen dem Emitter des npn-Vorstufen-Transistors und dem festen Potential und der Basis des npn-Vorstufen-Transistors und dem festen Potential ist jeweils ein elektrischer Widerstand angeordnet.

Vorteile und weitere Ausführungsformen der Verstärkerstufe ergeben sich aus den im folgenden in Verbindung mit den Figuren 1 bis 3 beschriebenen Ausführungsbeispielen. Es zeigen:
Figur 1 einen Schaltplan eines ersten Ausführungsbeispieles,
Figur 2 einen Schaltplan eines zweiten Ausführungsbeispieles und
Figur 3 eine schematische Darstellung eines integrierten Bausteines mit einer integrierten Verstärkerstufe gemäß der Erfindung.

In den Figuren sind gleiche oder gleichwirkende Bestandteile immer mit denselben Bezugszeichen versehen.

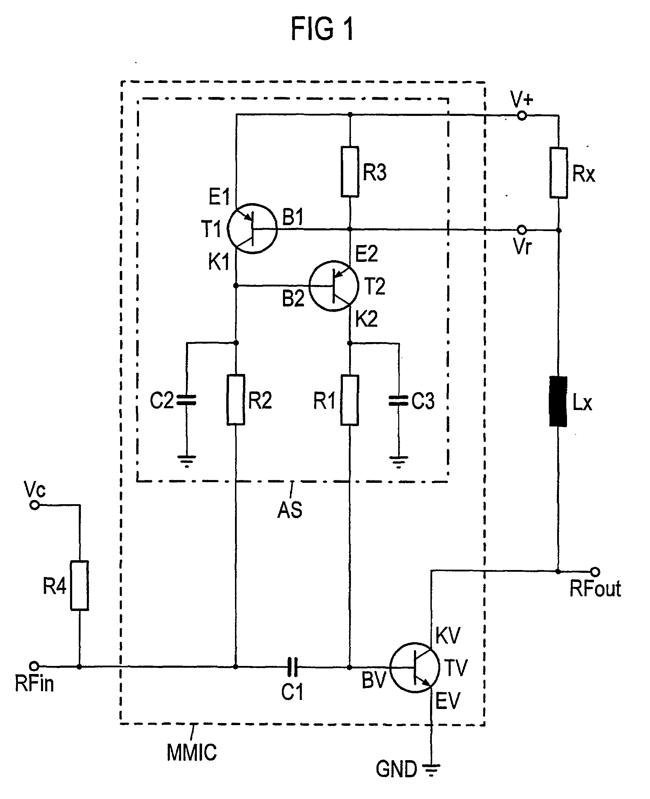

Bei der Schaltungsanordnung gemäß Figur 1 ist ein npn-Verstärker-Transistor TV mit seiner Basis BV an einen Wechselspannungs-Eingangsanschluss RFin, mit seinem Emitter EV an ein festes Potential GND und mit seinem Kollektor KV an einen Wechselspannungs-Ausgangsanschluss RFout angeschlossen. Zwischen einem Gleichspannungs-Eingangsanschluss V+ und der Basis BV des npn-Verstärkertransistors TV ist eine aktive Arbeitspunkt-Stabilisierungseinheit AS mit einem ersten T1 und einem zweiten pnp-Transistor T2 vorgesehen. Bei dieser ist der Kollektor K1 des ersten pnp-Transistors T1 mit der Basis B2 des zweiten pnp-Transistors T2, die Basis B1 des ersten pnp-Transistors T1 mit dem Emitter E2 des zweiten pnp-Transistors T2, der Emitter E1 des ersten pnp-Transistors T1 mit dem Gleichspannungs-Eingangsanschluss V+ und der Kollektor K2 des zweiten pnp-Transistors T2 über einen ersten elektrischen Widerstand R1 mit der Basis BV des npn-Verstärker-Transistors TV verbunden. An den Emitter E2 des zweiten pnp-Transistors T2 ist ein weiterer Schaltungsanschluss Vr angeschlossen.

Zwischen dem Wechselspannungs-Eingangsanschluß RFin und der Basis des npn-Verstärker-Transistors TV ist eine erste Kapazität C1 angeordnet. Dieser dient der Gleichstrom(DC)-Entkopplung und kann auch zur HF-Anpassung für den npn-Verstärker-Transistor TV verwendet werden.

Der Kollektor K1 des ersten pnp-Transistors T1 ist über einen zweiten elektrischen Widerstand R2 auch an den Wechselspannungs-Eingangsanschluß Rfin angeschlossen. Eine zweite Kapazität C2 und eine dritte Kapazität C3 sind einerseits an den Kollektor K1 des ersten pnp-Transistors T1 bzw. an den Kollektor K2 des zweiten pnp-Transistors T2 angeschlossen, und liegen andererseits auf einem festen Potential GND, bevorzugt Masse.

Sämtliche oben beschriebenen Schaltungselemente sind bevorzugt auf einem einzigen MMIC-Chip integriert. Zur On-Wafer-Messung der Transistor-Verstärkerstufe kann zwischen dem Gleichspannungs-Eingangsanschluß V+ und dem Emitter des zweiten pnp-Transistors T2 ein dritter elektrischer Widerstand R3 angeschlossen sein.

Im Betrieb der Transistor-Verstärkersufe gemäß dem Ausführungsbeispiel von Figur 1 ist zwischen dem Gleichspannungseingangsanschluß V+ und dem weiteren Schaltungsanschluss Vr ein externer elektrischer Widerstand Rx und zwischen dem weiteren Schaltungsanschluß Vr und dem Wechselspannungs-Ausgangsanschluß RFout eine erste Induktivität L1 angeschlossen. Mit dem externen elektrischen Widerstand Rx ist der exakte Betriebsstrom des Verstärker-Transistors TV einstellbar.

Weiterhin ist an den Wechselspannungs-Eingangsanschluß RFin über einen vierten elektrischen Widerstand R4 ein Steueranschluß Vc angeschlossen. Liegt der Steueranschluß Vc auf dem festen Potential GND kann sich ein Strom durch die aktive Arbeitspunkt-Stabilisierungseinheit AS einstellen. Liegt der Steueranschluß Vc auf High, sperrt der zweite pnp-Transistor T2. Dadurch kann der npn-Verstärker-Transistor TV ein- und ausgeschaltet werden.

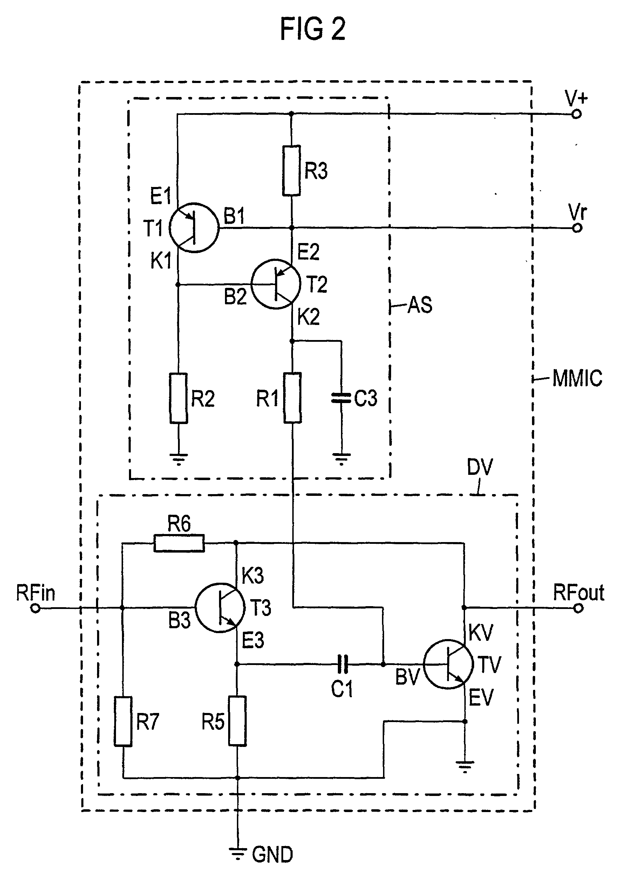

Der zweite elektrische Widerstand R2 kann anstatt mit dem Wechselspannungs-Eingangsanschluß RFin wie bei dem weiter unten beschriebenen Ausführungsbeispiel von Figur 2 mit dem festen Potential GND verbunden sein. Dann ist jedoch ein Einund Ausschalten des npn-Verstärker-Transistor TV nicht möglich.

Bei dem Ausführungsbeispiel von Figur 2 ist ein npn-Vorstufen-Transistors T3 vorgesehen ist, der so an den npn-Verstärker-Tranistor TV gekoppelt ist, dass er mit diesem zusammen eine an sich bekannte Darlington-Verstärkerstufe DV ausbildet. Der Emitter E3 des npn-Vorstufen-Transistors T3 ist über die erste Kapazität C1 an die Basis BV des npn-Verstärker-Transistors TV sowie über einen fünften elektrischen Widerstand R5 an das feste Potential GND angeschlossen. Weiterhin ist von dem npn-Vorstufen-Transistors T3 der Kollektor K3 mit dem Kollektor KV des npn-Verstärker-Transistors TV und über einen sechsten elektrischen Widerstand R6 mit seiner Basis B3 verbunden. Die Basis B3 des npn-Vorstufen-Transistors T3 ist an den Wechselspannungs-Eingangsanschluß RFin und über einen siebten elektrischen Widerstand R7 an das feste Potential GND angeschlossen.

Der zweite elektrische Widerstand R2 ist hier anstatt, wie beim Ausführungsbeispiel von Figur 1, mit dem Wechselspannungs-Eingangsanschluß RFin mit dem festen Potential GND verbunden. Um ein Ein- und Ausschalten des npn-Verstärker-Transistor TV zu ermöglichen, kann der zweite elektrische Widerstand R2 analog Figur 1 angeschlossen sein.

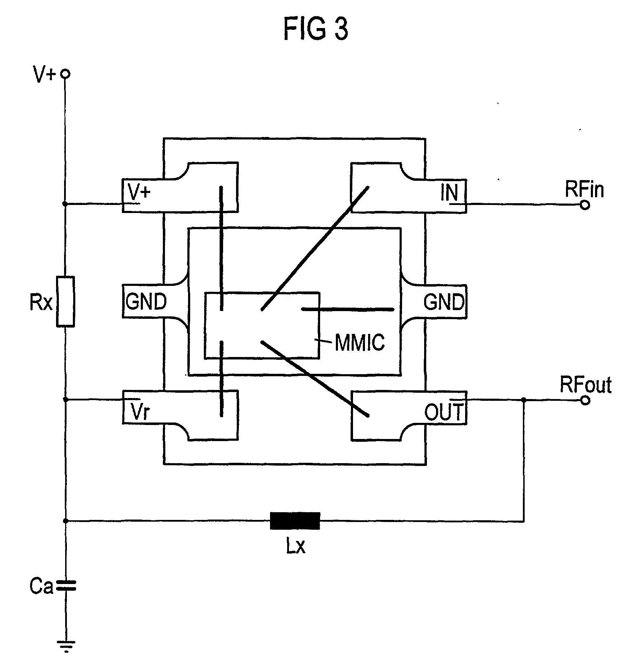

Für den Betrieb der Transistor-Verstärkerstufe ist, wie in Figur 3 gezeigt, neben dem externen Widerstand Rx auch eine Abblockkapazität Ca am weiteren Schaltungsanschluß Vr vorgesehen. Die externe Induktivität Lx versorgt den Baustein mit der Betriebsspannung und trennt wechselspannungsmäßig den Wechselspannungs-Ausgangsanschluß RFout von der Betriebsspannung.

Bei dem in Figur 3 gezeigten Baustein ist auf einer Chipmontagefläche eines Leadframes der MMIC-Chip befestigt. Dieser ist mittels Bonddrähten mit den weiteren von der Chipmontagefläche getrennt angeordneten Anschlußpins verbunden. Hierbei handelt es sich um eine an sich bekannte Technik, die von daher nicht näher erläutert wird. Die Figur 3 zeigt weiterhin die externe Beschaltung des Bausteins mit der Induktivität Lx, mit dem externen Widerstand Rx sowie mit der Abblockkapazität Ca.

## Patentansprüche

1. Transistor-Verstärkerstufe mit npn-Verstärker-Transistor (TV), bei der der npn-Verstärker-Transistor (TV) mit seiner Basis (BV) an einen Wechselspannungs-Eingangsanschluß (RFin), mit seinem Emitter (EV) an ein festes Potential (GND) und mit seinem Kollektor (KV) an einen Wechselspannungs-Ausgangsanschluß (RFout) gekoppelt ist, wobei zwischen einem Gleichspannungs-Eingangsanschluß (V+) und der Basis (BV) des npn-Verstärker-Transistors (TV) eine aktive Arbeitspunkt-Stabilisierungseinheit (AS) mit einem ersten (T1) und einem zweiten pnp-Transistor (T2) vorgesehen ist, bei der der Kollektor (K1) des ersten pnp-Transistors (T1) an die Basis (B2) des zweiten pnp-Transistors (T2), der Emitter (E1) des ersten pnp-Transistors (T1) an den Gleichspannungs-Eingangsanschluß (V+) und der Kollektor (K2) des zweiten pnp-Transistors (T2) an die Basis (BV) des npn-Verstärker-Transistors (TV) gekoppelt ist, **dadurch gekennzeichnet, dass** die Basis (B1) des ersten pnp-Transistors (T1) an den Ermitter (E2) des zweiten pnp-Transistors (T2) gekoppelt ist, und an den Emitter des zweiten pnp-Transistors (T2) ein weiterer Schaltungsanschluß (Vr) gekoppelt ist.

2. Verstärkerstufe nach Anspruch 1,
**dadurch gekennzeichnet, dass**
zwischen der Basis (BV) des npn-Verstärker-Transistors (TV) und dem Kollektor (K2) des zweiten pnp-Transistors (T2) ein erster elektrischer Widerstand (R1) angeordnet ist.

3. Verstärkerstufe nach Anspruch 1 oder 2,
**dadurch gekennzeichnet, dass**
der Kollektor (K1) des ersten pnp-Transistors (T1) an das feste Potential (GND) oder an einen Kontrollanschluß (Vc) gekoppelt ist.

4. Verstärkerstufe nach einem der Ansprüche 1 bis 3,
**dadurch gekennzeichnet, dass**
ein npn-Vorstufen-Transistors (T3) vorgesehen ist, der so an den npn-Verstärker-Tranistor (TV) gekoppelt ist, dass er mit diesem zusammen eine Darlington-Verstärkerstufe ausbildet.

5. Verstärkerstufe nach Anspruch 4,
**dadurch gekennzeichnet, dass**
von dem npn-Vorstufen-Transistors (T3) der Emitter (E3) an die Basis (BV) des npn-Verstärker-Transistors (TV) sowie an das feste Potential (GND), der Kollektor (K3) an den Kollektor (KV) des npn-Verstärker-Transistors (TV) und die Basis (B3) an den Wechselspannungs-Eingangsanschluß (Rfin) gekoppelt ist, und
zwischen der Basis (B3) und dem Kollektor (K3) des npn-Vorstufen-Transistors (T3) sowie zwischen dem Emitter (E3) des npn-Vorstufen-Transistors (T3) und dem festen Potential (GND) und zwischen der Basis (B3) des npn-Vorstufen-Transistors (T3) und dem festen Potential (GND) jeweils ein elektrischer Widerstand (R5,R6,R7) angeordnet ist.

## Claims

1. Transistor amplifier stage having an npn amplifier transistor (TV), in which the base (BV) of the npn amplifier transistor (TV) is coupled to an AC voltage input connection (RFin), the emitter (EV) of the npn amplifier transistor (TV) is coupled to a fixed potential (GND), and the collector (KV) of the npn amplifier transistor (TV) is coupled to an AC voltage output connection (RFout), where an active operating point stabilization unit (AS) having a first pnp transistor (T1) and a second pnp transistor (T2) is provided between a DC voltage input connection (V+) and the base (BV) of the npn amplifier transistor (TV), in which stabilization unit the collector (K1) of the first pnp transistor (T1) is coupled to the base (B2) of the second pnp transistor (T2), the emitter (E1) of the first pnp transistor (T1) is coupled to the DC voltage input connection (V+), and the collector (K2) of the second pnp transistor (T2) is coupled to the base (BV) of the npn amplifier transistor (TV), **characterized in that** the base (B1) of the first pnp transistor (T1) is coupled to the emitter (E2) of the second pnp transistor (T2), and a further circuit connection (Vr) is coupled to the emitter of the second pnp transistor (T2).

2. Amplifier stage according to Claim 1,
**characterized in that**
a first electrical resistor (R1) is arranged between the base (BV) of the npn amplifier transistor (TV) and the collector (K2) of the second pnp transistor (T2).

3. Amplifier stage according to Claim 1 or 2,
**characterized in that**
the collector (K1) of the first pnp transistor (T1) is coupled to the fixed potential (GND) or to a control connection (Vc).

4. Amplifier stage according to one of Claims 1 to 3,
**characterized in that**
an npn input stage transistor (T3) is provided which is coupled to the npn amplifier transistor (TV) such that it forms a Darlington amplifier stage together with said npn amplifier transistor.

5. Amplifier stage according to Claim 4,
**characterized in that**
the emitter (E3) of the npn input stage transistor (T3) is coupled to the base (BV) of the npn amplifier transistor (TV) and also to the fixed potential (GND), the collector (K3) of the npn input stage transistor (T3) is coupled to the collector (KV) of the npn amplifier transistor (TV), and the base (B3) of the npn input stage transistor (T3) is coupled to the AC voltage input connection (RFin), and
a respective electrical resistor (R5, R6, R7) is arranged between the base (B3) and the collector (K3) of the npn input stage transistor (T3) and also between the emitter (E3) of the npn input stage transistor (T3) and the fixed potential (GND) and between the base (B3) of the npn input stage transistor (T3) and the fixed potential (GND).

## Revendications

1. Etage amplificateur à transistor ayant un transistor (TV) amplificateur npn, dans lequel le transistor (TV) amplificateur npn est couplé par sa base (BV) à une borne (RFin) d'entrée de tension alternative, par son émetteur (EV) à un potentiel (GND) fixe et par son collecteur (KV) à une borne (RFout) de sortie de tension alternative, une unité (AS) active de stabilisation du point de travail, ayant un premier transistor (T1) pnp et un deuxième transistor (T2) pnp, étant prévue entre une borne (V+) d'entrée de tension continue et la base (BV) du transistor (TV) amplificateur npn, dans lequel le collecteur (K1) du premier transistor (T1) pnp est couplé à la base (B2) du deuxième transistor (T2) pnp, l'émetteur (E1) du premier transistor (T1) pnp est couplé à la borne (V+) d'entrée de tension continue, et le collecteur (K2) du deuxième transistor (T2) pnp est couplé à la base (BV) du transistor (TV) amplificateur npn, **caractérisé en ce que** la base (G1) du premier transistor (T1) pnp est couplé à l'émetteur (E2) du deuxième transistor (T2) pnp, et une autre borne (Vr) de circuit est couplée à l'émetteur du deuxième transistor (T2) pnp.

2. Etage amplificateur suivant la revendication 1, **caractérisé en ce qu'**une première résistance (R1) est montée entre la base (BV) du transistor (TV) amplificateur npn et le collecteur (K2) du deuxième transistor (T2) pnp.

3. Etage amplificateur suivant la revendication 1 ou 2, **caractérisé en ce que** le collecteur (K1) du premier transistor (T1) pnp est couplé au potentiel (GND) fixe ou à une borne (Vc) de contrôle.

4. Etage amplificateur suivant l'une des revendications 1 à 3, **caractérisé en ce qu'**il est prévu un transistor (T3) d'étage préliminaire npn, qui est couplé au transistor (TV) amplificateur npn de manière à former avec lui un étage amplificateur Darlington.

5. Etage amplificateur suivant la revendication 4, **caractérisé en ce que** par le transistor (T3) d'étage préliminaire npn, l'émetteur (E3) est couplé à la base (BV) du transistor (TV) amplificateur npn, ainsi qu'au potentiel (GND) fixe, le collecteur (K3) au collecteur (KV) du transistor (TV) amplificateur npn, et la base (B3) à la borne (RFin) d'entrée de tension alternative, et
il est monté entre la base (B3) et le collecteur (K3) du transistor (T3) d'étage préliminaire npn, ainsi qu'entre l'émetteur (E3) du transistor (T3) d'étage préliminaire npn et le potentiel (GND), et entre la base (B3) du transistor (T3) d'étage préliminaire npn et le potentiel (GND) fixe respectivement, une résistance (R5, R6, R7) électrique.
